(19) Europäisches Patentamt
European Patent Office
Office européen des brevets

(11) **EP 1 721 183 B1**

(12) **EUROPÄISCHE PATENTSCHRIFT**

(45) Veröffentlichungstag und Bekanntmachung des Hinweises auf die Patenterteilung:
**08.12.2010 Patentblatt 2010/49**

(51) Int Cl.:
***G01R 33/07*** *(2006.01)*   ***G01B 7/30*** *(2006.01)*

(21) Anmeldenummer: **05700809.6**

(22) Anmeldetag: **11.01.2005**

(86) Internationale Anmeldenummer:
**PCT/EP2005/000176**

(87) Internationale Veröffentlichungsnummer:
**WO 2005/085892 (15.09.2005 Gazette 2005/37)**

(54) **MAGNETFELDSENSOR UND VERFAHREN ZU SEINEM BETRIEB**

MAGNETIC FIELD SENSOR AND METHOD FOR THE OPERATION THEREOF

CAPTEUR A CHAMP MAGNETIQUE ET PROCEDE D'UTILISATION

(84) Benannte Vertragsstaaten:
**FR GB IE IT**

(30) Priorität: **02.03.2004 DE 102004010613**

(43) Veröffentlichungstag der Anmeldung:
**15.11.2006 Patentblatt 2006/46**

(73) Patentinhaber: **austriamicrosystems AG**
**8141 Unterpremstätten (AT)**

(72) Erfinder:
• **ROSSMANN, Siegfried**
  **A-9125 Kuehnsdorf (AT)**
• **STEELE, Colin**
  **Edinburgh EH9 2EG (GB)**

(74) Vertreter: **Epping - Hermann - Fischer**
**Patentanwaltsgesellschaft mbH**
**Ridlerstrasse 55**
**80339 München (DE)**

(56) Entgegenhaltungen:
**DE-A1- 4 422 868    DE-A1- 10 154 498**
**US-A- 5 426 364    US-A- 5 477 135**

EP 1 721 183 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft einen Magnetfeldsensor mit einer Sensoranordnung, die von einem Versorgungseinrichtung versorgt wird und ein Sensorsignal erzeugt, und mit einer Auswerteeinrichtung, der das Sensorsignal zugeführt wird und die ein Ausgangssignal abgibt. Die Erfindung betrifft weiter ein Verfahren zum Betrieb des Magnetfeldsensors.

Ein solcher, aus der EP 0525235 B1 bekannter Magnetfeldsensor weist eine Selbstkompensation auf, bei der durch eine thermische und technologische Kopplung eines Hallelementes und seiner Versorgungseinrichtungen individuelle Abgleichmaßnahmen des Magnetfeldsensors unnötig werden. Dazu sind die entsprechenden Elemente in einer integrierten Schaltung gemeinsam ausgeführt.

Ein weiterer Magnetfeldsensor der genannten Art ist aus der DE 4431703 A1 bekannt. Dort wird ein Magnetfeldsensor vorgeschlagen, der neben einer Kompensation des Offsets des Hallelements den Offset der nachgeschalteten Auswerteeinrichtung mitberücksichtigt und somit eine größere Genauigkeit ermöglicht.

Hallelements sind typische Sensorelemente, mit denen ein Magnetfeldsensor aufgebaut werden kann und die meistens in einem Array bzw. einer Hallelementanordnung zusammenwirken. Ein Hallelement gibt im Magnetfeld als Hallsignal ein Spannungssignal ab, wenn es von einem Strom senkrecht zum Magnetfeld durchflossen wird. Das Hallsignal, d.h. die Hallspannung, ist abhängig von dem Produkt aus der vertikalen Komponente der magnetischen Flussdichte, dem Hallstrom und der Hallkonstanten. Die Hallkonstante, die die Sensitivität des Hallelements angibt, ist materialabhängig.

Ein weiterer Magnetfeldsensor ist aus US 5477 135 bekannt. Es beschreibt ein Magnetfeldsensor mit Hallelement und mit einer Rückkopplungsschicht.

Im praktischen Betrieb überlagert sich dem Nutzsignal der Hallspannung aus Hallkonstante des Baulements, der vertikalen Komponente der magnetischen Flussdichte und dem Hallstrom eine Rauschspannung, die sich aus Rauschkomponenten des Hallelementes und der nachfolgenden Auswerteeinrichtung zusammensetzt. Derartige Rauschkomponenten können durch eine Temperatur- und Materialabhängigkeit gegeben sein.

Weitere Komponenten des Rauschsignals können aus der konkreten Anwendung entstehen. So gibt die EP 0916074 B1 einen magnetischen Drehsensor an, bei dem ein auf einer Achse montierter Magnet über einem Hallelementarray angeordnet ist. Die Hallelementanordnung selbst besteht aus einer Anzahl von einzelnen Sensorelementen, die in einer bestimmten geometrischen Anordnung zueinander stehen. Die dem Hallelementarray nachgeschaltete Auswerteeinrichtung ermittelt aus dem Hallsignal des Hallelementes den Drehwinkel der Achse. Unterschiedliche Temperaturgänge des Magneten sowie des Hallelementes sowie unterschiedliche Abstände zwischen diesen beiden Elementen beeinflussen insbesondere das Nutzsignal. Dadurch wird der Abstand zwischen Nutzsignal und Rauschsignal verändert.

Wird das Hallsignal für Zwecke einer digitalen Weiterverarbeitung digitalisiert, so kann aufgrund der Änderungen der Nutzsignalamplitude des Hallsignals der Dynamikbereich des Analog-Digital-Wandlers, der die Digitalsierung ausführt, nicht voll ausgeschöpft werden.

Der Erfindung liegt die Aufgabe zugrunde, einen Magnetfeldsensor und ein Verfahren zu seinem Betrieb anzugeben, mit denen sich ein besseres Verhalten des Magnetfeldsensors ergibt.

Diese Aufgabe wird durch einen Magnetsensor und durch ein Verfahren zu seinem Betrieb gemäß den unabhängigen Ansprüchen gelöst. Vorteilhafte Ausgestaltungen der Erfindung sind in weiteren Ansprüchen gekennzeichnet.

Der Erfindung liegt der Gedanke zugrunde, das Sensorsignal bzw. das Ausgangssignal der Auswerteeinrichtung des Magnetfeldsensors aufzubereiten und mit Hilfe einer Rückkopplungseinrichtung ein Steuersignal zu erzeugen, mit dem die Größe des Versorgungsstroms oder der Versorgungsspannung verändert werden kann. Dazu wird bevorzugt die Amplitude des Sensorsignals ermittelt und der Versorgungsstroms oder die Versorgungsspannung der Sensoranordnung in einem geschlossenen Regelkreis so eingestellt, dass die Amplitude des Sensorsignals konstant bleibt.

Es ist besonders vorteilhaft, dass mit einem derartigen Magnetfeldsensor und mit dem Verfahren zu seinem Betrieb ein Ausgangssignal des Magnetfeldsensors erzeugt werden kann, das ein optimiertes Signal-zu-Rausch-Verhältnis aufweist.

Es ist weiterhin vorteilhaft, dass der bei einer digitalen Weiterverarbeitung des Sensorsignals notwendige Analog-Digital-Wandler (ADC) eine geringere Bitbreite aufweisen kann als ohne die Regelung notwendig wäre. Damit kann der ADC einfacher und kostengünstiger aufgebaut sein.

Es ist besonders vorteilhaft, wenn das Ausgangssignal der Auswerteeinrichtung der Amplitude des Sensorsignals entspricht und diese durch einen Vergleich mit einem Amplitudensollwert ermittelt wird. Der Versorgungsstroms oder die Versorgungsspannung wird dann mit der Verstärkungseinrichtung so eingestellt, dass die Amplitude des Sensorsignals konstant bleibt.

Bei einer Ausführung des Magnetfeldsensors mit Hallelementen werden die einzelnen Elemente der Hallelementanordnung bevorzugt so angeordnet werden, dass sie zwei um 90° phasenverschobene Messsignale erzeugen, insbesondere werden die Hallelemente um 90° gegeneinander versetzt angeordnet. Bei einem Drehwinkelsensor kann dann die Amplitude des Hallsignals in einfacher Weise ermittelt werden. Bei einem sinusförmigen Verlauf der beiden phasenverschobenen Messsignale lässt sich die Amplitude durch eine Quadrierung jedes Messsignals und anschließende Addition der quadrierten Signale erzeugen.

In einer vorteilhaften Ausgestalung ist vorgesehen, dass die Messsignale der Sensoranordnung digitalisiert und in einer Recheneinrichtung weiterverarbeitet werden. Die Recheneinrichtung erzeugt einerseits das gewünschte Ausgangssignal, beispielsweise den Drehwinkel, und andererseits die Amplitudeninformation für das Sensorsignal.

In einer besonders bevorzugten Ausführungsform ist vorgesehen, dass die Rückkopplungseinrichtung einen Komparator enthält, der das Amplitudensignal des Magnetfeldsensors mit einem Referenzwert vergleicht, dass dem Komparator ein Zähler nachgeschaltet ist, der abhängig vom Ausgangssignal des Komparators aufwärts oder abwärts zählt und dass der Wert des Zählers mit einem Digital-Analog-Wandler (DAC) in ein Steuersignal für den Versorgungsstrom oder die Versorgungsspannung umgewandelt wird.

In einer weiteren vorteilhaften Ausgestaltung ist vorgesehen, dass sich der Versorgungsstrom oder die Versorgungsspannung aus einer Gleichkomponente und einer steuerbaren Komponente, z.B. aus einem Gleichstrom einer Konstantstromquelle und dem Strom einer gesteuerten Stromquelle zusammensetzt, wobei die gesteuerte Komponente von der Rückkopplungs- bzw. Verstärkungseinrichtung gesteuert wird. Auf diese Weise ist die Funktion des Magnetfeldsensors sichergestellt, wenn die gesteuerte Komponente nicht angesteuert wird.

In weiteren vorteilhaften Ausgestaltung der Erfindung ist vorgesehen, dass die Steuersignale für den im Rückkopplungszweig vorgesehenen Zähler als Statusinformation verwendet und aufbereitet werden. Auf diese Weise lässt sich der Status der Regeleinrichtung, insbesondere die Erhöhung oder Verminderung der Steuerinformation der gesteuerten Komponente und damit der Amplitude des Sensorsignals oder ein Überlauf des Zählers und damit ein Verlassen des Regelbereichs des Magnetfeldsensors feststellen. Weiterhin kann mit einer derartigen Statusinformation eine dynamische Erkennung einer "Push-Hutton"-Funktion unabhängig vom Absolutwert verwendet werden.

Die Erfindung wird nachfolgend anhand von Ausführungsbeispielen und dazugehörigen Figuren der Zeichnung näher erläutert. Die Figuren dienen allein der Veranschaulichung der Erfindung und sind daher nur schematisch und nicht maßstabsgetreu ausgeführt. Gleiche oder gleichwirkende Elemente sind mit gleichen Bezugszeichen versehen. Es zeigen

Figur 1 einen schematischen Aufbau eines Magnetfeldsensors mit einer Hallelementanordnung,

Figur 2 eine detailliertere schematische Darstellung der Verstärkungseinrichtung und

Figur 3 eine schematische Anordnung eines Drehfeldsensors.

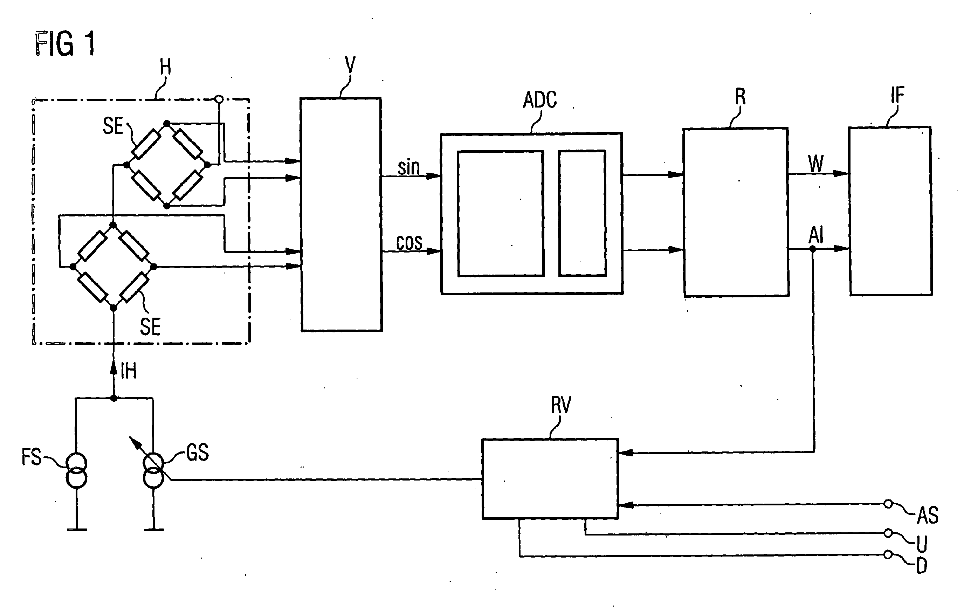

Die Erfindung wir nachfolgend anhand eines Magnetfeldsensors mit Hallelmentanordnung beschrieben. Gemäß Figur 1 ist ein Magnetfeldsensor H, insbesondere eine Hallelementanordnung; vorgesehen, der vorzugsweise aus mehreren Sensorelementen SE besteht. Bevorzugt sind jeweils vier Sensorelemente zu einer Sensoranordnung zusammengefasst.

Die Hallelemente des Sensors H werden einzeln von einer Versorgungseinrichtung versorgt bzw. im Ausführungsbeispiel von einer Stromquelle gespeist, die eine Fixstromquelle FS und eine gesteuerte Stromquelle GS enthält. Die Fixstromquelle FS erzeugt mit einer nicht näher dargestellten Spannungs- und Stromversorgungseinrichtung des Magnetfeldsensors einen fixen Betriebsstrom für die Hallelemente des Magnetfeldsensors H. Die gesteuerte Stromquelle GS erzeugt den von dem Rückkopplungszweig bestimmten gesteuerten Strom. Beide Teilströme bilden den Hallstrom IH.

Die beiden Hall-Sensoranordnungen sind so ausgerichtet, dass die von ihnen erzeugten Messsignale um 90° gegeneinander phasenverschoben sind. Wenn bei einer bevorzugten Ausführungsform der Magnetfeldsensor ein Drehsensor ist, hat das erste Messsignal sinusförmigen Verlauf, während das zweite Messsignal cosinusförmigen Verlauf hat. Nach einer Vorverstärkung im Vorverstärker V gelangen beide Messsignale zum Analog-Digital-Wandler ADC. Dieser führt die Analog-Digital-Wandlung durch, beispielsweise mit Hilfe eines Sigma-Delta-Modulators, so dass nach einer gegebenenfalls noch vorgesehenen digitalen Filterung am Ausgang des ADC ein digitalisiertes Sinus- und ein digitalisiertes Cosinus-Signal verfügbar sind. Beide Signale werden anschließend in der Recheneinrichtung R verknüpft und verarbeitet.

Die Recheneinrichtung R.führt mit den digitalisierten Signalen einen Algorithmus aus, so dass am Ausgang der Recheneinrichtung das oder die gewünschten Ausgangssignale bereit stehen. Im Beispiel eines Drehfeldsensors steht so der Winkel W zur Verfügung und wird an ein Interface IF eingespeist, das die Signalausgabe an externe Anschlüsse vorsieht oder eine weitere Verarbeitung des digitalen Winkelsignals W durchführt.

Als anderes Ausgangssignal der Recheneinrichtung steht die Istwert-Amplitude AI des Hallsignals aus den beiden Messsignalen zur Verfügung. Die Recheneinrichtung R führt dazu die mathematische Beziehung

$$\sin^2 W + \cos^2 W = 1$$

aus.

Die Recheneinrichtung R ist üblicherweise als digitaler Signalprozessor (DSP) ausgebildet. Im Fall eines Drehfeldsensors wird dieser auch als CORDIC (Cordinate Rotational Digital Computer) bezeichnet. Ein möglicher Algorithmus ist in der "IEEE Transactions on Circuits and Systems - II: Analog and Digital Signal Processing", Vol. 48, No. 6, June 2001, PP 548 bis 561 beschrieben. Selbstverständlich kann ein derartiger CORDIC auch andere Algorithmen ausführen. Ebenso ist bei einer anderen vom Magnetfeldsensor zu erfassenden Messgröße mit dem digitalen Prozessor die Ausführung eines anderen Algorithmus im DSP möglich.

Die Istwert-Amplitude AI des Hallsignals wird nun in einer Rückkopplungsschleife einer Rückkopplungseinrichtung RV zugeführt, die an ihrem Ausgang ein Steuersignal zur Steuerung der gesteuerten Stromquelle GS abgibt. Die Rückkopplungseinrichtung ist in Figur 1 eine Verstärkungseinrichtung und kann auch als AGC (Automatic Gain Control) bezeichnet werden. An einem zweiten Eingang ist der Rückkopplungseinrichtung RV ein Sollsignal AS für die Amplitude des Hallsignals zugeführt.

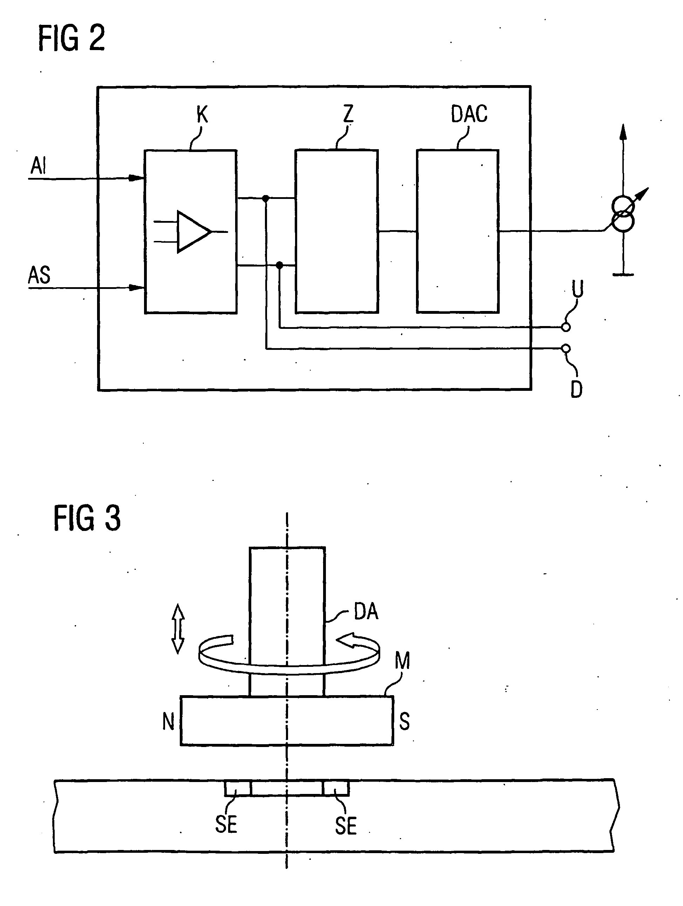

Gemäß Figur 2, die Einzelheiten des Aufbaus der Rückkopplungs- bzw. Verstärkungseinrichtung RV darstellt, enthält die Verstärkungseinrichtung einen digitalen Komparator K, einen Zähler Z und einen Digital-Analog-Wandler DAC. Dem digitalen Komparator werden der Istwerte der Amplitude AI und die Sollwerte der Amplitude AS des Hallsignals zugeführt. Der Sollwert AS entspricht bevorzugt einer optimalen Amplitude am Eingang des ADC.

Der digitale Komparator K erzeugt aus seinen beiden Eingangssignalen AI und AS ein Ausgangssignal, das einem Zähler Z zugeführt wird. Der Zähler Z ist als Aufwärts/Abwärts-Zähler ausgebildet. Der Wert des Zählers ergibt sich beispielsweise durch Zählen einer Taktfrequenz. Im Beispiel der Figur 2 sind zwei Ausgangssignale U und D des Komparators K an gleichnamigen Anschlüssen vorgesehen, von denen Ausgang U aktiviert wird, wenn der Zähler Z aufwärts zählen soll, während der Ausgang D aktiviert wird, wenn der Zähler Z abwärts zählen soll.

Ausgangsseitig wird der Zählerwert dem Digital-/Analog-Wandler DAC zugeführt, der den Zählerwert in ein analoges Signal umsetzt, das wiederum die nicht näher dargestellte gesteuerte Stromquelle GS steuert. Die gesteuerte Stromquelle kann im übrigen in aus dem Stand der Technik bekannter Weise ausgeführt sein.

Der Ausgang des digitalen Komparators K ist parallel zum Zähler separat an den Klemmen U und D herausgeführt. Die Steuersignale U und D für den Zähler Z können als Statusinformation für den Magnetfeldsensor verwendet werden. So wird beispielsweise bei einer Änderung des Abstandes zwischen dem Magneten und dem Hallsensor eine Nachregelung des Hallstroms mit Hilfe des beschriebenen Regelkreises notwendig. Die Regelung des mit der Rückkopplungseinrichtung RV geschlossenen Regelkreises verbessert das Rauschverhalten des Magnetfeldsensors.

Mit Hilfe der als Statusinformation verwendeten Steuersignale für den Zähler kann dieses Nachregeln des Regelkreises angezeigt werden, weil ein Signal U für das Aufwärtszählen und das andere Signal D für das Abwärtszählen kennzeichnend ist. Somit kann auf einfache Weise extern festgestellt werden, ob sich der Abstand zwischen Magnet und Hallelement verändert hat und in welcher Richtung er sich verändert hat. Außerdem ist es möglich durch eine Aktivierung beider Signale U bzw. D einen Zählerüberlauf über den oberen zulässigen Wert oder nach unten unter den unteren zulässigen Wert anzuzeigen, was einem Verlassen des Regelbereichs der Verstärkungseinrichtung entspricht. Auf diese Weise können Fehler einfach festgestellt werden.

Aufgrund der Steuerung der Amplitude des Hallsignals können die Elemente des Magnetfeldsensors optimal an die gegebenen Einsatzbedingungen angepasst werden. So ist es möglich, die Bitbreite des ADC um ein oder gar zwei Bit gegenüber einer nicht geregelten Ausführungsform zu reduzieren. Dadurch können diese Elemente weniger aufwendig und damit kostengünstiger realisiert werden.

Figur 3 schließlich zeigt zur Veranschaulichung die aus der EP 0916074 B1 bekannte Drehsensoranordnung. Auf einer Drehachse DA ist ein Magnet über einem Hallelement H mit nachfolgender Auswerteschaltung angebracht. Die Erfindung ermöglicht nun eine verbesserte Messung und Auswertung, die gegenüber Abstandsänderungen zwischen Magnet und Hallelementanordnung ein weitgehend unabhängiges Signal-Rausch-Verhältnis hat. Grundsätzlich können auch Signaländerungen, die auf einem aus der Vertikalen verkippten Hallelement-Magnet-Verhältnis oder einer nicht zentrischen Hallelement-Magnet-Beziehung beruhen, zumindest teilweise kompensiert werden und so ein besseren Nutzsignal ermöglichen.

Es ist zu erwähnen, dass die Erfindung nicht auf Hallanordnungen beschränkt ist, sondern dass der Gedanke der geregelten Sensoranordnung auch mit anderen Sensoren realisiert werden kann, die auf anderen physikalischen Prinzipien beruhen.

**Patentansprüche**

1. Magnetfeldsensor mit einer Sensoranordnung (H), die von einer Versorgungseinrichtung versorgt wird und ein Sensorsignal erzeugt, mit einer Auswerteeinrichtung (ADC, R), der das Sensorsignal zugeführt wird und die ein der Amplitude des Sensorsignals entsprechendes erstes Ausgangssignal (AI) abgibt, und mit einer Rückkopplungseinrichtung (RV), der das erste Ausgangssignal zugeführt ist, **dadurch gekennzeichnet, daß** die Versorgungseinrichtung so angestenert wird, dass das erste Ausgangssignal konstant bleibt.

2. Magnetfeldsensor nach Anspruch 1, **dadurch gekennzeichnet, dass** die Sensoranordnung eine Hallelementanordnung (H) enthält, die von einem Hallstrom (IH) gespeist wird und als Sensorsignal ein Hallsignal erzeugt, und mit einer als Verstärkungseinrichtung (RV) ausgeführten Rückkopplungseinrichtung, der das erste Ausgangssignal zugeführt ist und die den Hallstrom steuert.

**3.** Magnetfeldsensor nach Anspruch 1 oder 2, **dadurch gekennzeichnet, dass** das erste Ausgangssignal der Istwert-Amplitude(AI) des Sensorsignals entspricht und die Rückkopplungseinrichtung (RV) mit Hilfe einer vorgegebenen Sollwert-Amplitude (AS) die Versorgungseinrichtung so einstellt, dass die Istwert-Amplitude des Sensorsignals konstant bleibt.

**4.** Magnetfeldsensor nach einem der Ansprüche 2 oder 3, **dadurch gekennzeichnet, dass** die Hallelementanordnung ein magnetisches Drehfeld erfasst und ein zweites Ausgangssignal (W) der Auswerteeinrichtung dem ermittelten Drehwinkel entspricht.

**5.** Magnetfeldsensor nach einem der Ansprüche 2 bis 4, **dadurch gekennzeichnet, dass** das Hallsignal der Hallelementanordnung ein erstes Messsignal (sin W) und ein zweites Messsignal (cos W) enthält, das um 90° phasenverschoben gegenüber dem ersten Messsignal ist.

**6.** Magnetfeldsensor nach einem der Ansprüche 1 bis 5, **dadurch gekennzeichnet, dass** die Auswerteeinrichtung einen Analog-Digital-Wandler (ADC), der das Sensorsignal digitalisiert, enthält und eine nachgeschaltete Recheneinrichtung (R), die das erste und/oder das zweite Ausgangssignal (AI, W) erzeugt.

**7.** Magnetfeldsensor nach einem der Ansprüche 1 bis 6, **dadurch gekennzeichnet, dass** die Rückkopplungseinrichtung einen Komparator enthält (K), der das erste Ausgangssignal (AI) mit einem Referenzwert (AS) vergleicht, dass dem Komparator ein Zähler (Z) nachgeschaltet ist, dem das Ausgangssignal des Komparators zugeführt ist, und dass dem Zähler ein Digital-Analog-Wandler (DAC) nachgeschaltet ist, der das Ausgangssignal des Zählers in ein Steuersignal für die Versorgungseinrichtung umwandelt.

**8.** Verfahren zum Betrieb eines Magnetfeldsensors, insbesondere eines Magnetfeldsensors nach einem der Ansprüche 1 bis 6, bei dem eine Versorgungseinrichtung ein Sensorelement des Magnetfeldsensors versorgt und das Sensorelement ein Sensorsignal erzeugt, das mit einer Auswerteeinrichtung (ADC, R) zu einem der Amplitude des Sensorsignals entsprechenden ersten Ausgangssignal (AI) aufbereitet und einer Rückkopplungseinrichtung (RV) zugeführt wird, die ausgangsseitig die Versorgungseinrichtung so steuert, dass das erste Ausgangsignal konstant bleibt.

**9.** Verfahren nach Anspruch 8, **dadurch gekennzeichnet, dass** aus dem ersten Ausgangssignal die Istwert-Amplitude(AI) des Sensorsignals abgeleitet wird und die Rückkopplungseinrichtung (RV) mit Hilfe einer vorgegebenen Sollwert-Amplitude (AS) die Versorgungseinrichtung so einstellt, dass die Istwert-Amplitude des Sensorsignals konstant bleibt.

**10.** Verfahren nach Anspruch 8 oder 9, **dadurch gekennzeichnet, dass** mit dem Sensorelement ein magnetisches Drehfeld erfasst wird und mit der Auswerteeinrichtung ein zweites Ausgangssignal (W) erzeugt wird, das dem Drehwinkel entspricht.

**11.** Verfahren nach einem der Ansprüche 8 bis 10, **dadurch gekennzeichnet, dass** ein als Hallelementanordnung ausgeführtes Sensorelement so angeordnet ist, dass das Hallsignal ein erstes Messsignal (sin W) und ein zweites Messsignal (cos W) enthält, das um 90° phasenverschoben gegenüber dem ersten Messsignal ist.

**12.** Verfahren nach einem der Ansprüche 8 bis 11, **dadurch gekennzeichnet, dass** die Auswerteeinrichtung das Sensorsignal mit einem Analog-Digital-Wandler (ADC) digitalisiert, und eine der Auswerteeinrichtung nachgeschaltete Recheneinrichtung (R) das erste und/oder das zweite Ausgangssignal (AI, W) erzeugt.

**13.** Verfahren nach einem der Ansprüche 8 bis 12, **dadurch gekennzeichnet, dass** das erste Ausgangssignal (AI) in einem Komparator mit einem Referenzwert (AS) verglichen wird, dass ein dem Komparator nachgeschalteter Zähler (Z) einen Zählwert aus dem Ausgangssignal des Komparators ableitet und ein Digital-Analog-Wandler (DAC) das Ausgangssignal des Zählers in ein Steuersignal für die Versorgungseinrichtung umwandelt.

**Claims**

**1.** A magnetic field sensor comprising a sensor arrangement (H) which is supplied by a supply device and generates a sensor signal, an evaluation device (ADC, R) which is supplied with the sensor signal and outputs a first output signal (A1) corresponding to the amplitude of the sensor signal, and a feedback device (RV) supplied with the first output signal, **characterized in that** the supply device is controlled such that the first output signal remains constant.

**2.** The magnetic field sensor according to claim 1, **characterized in that** the sensor arrangement comprises a Hall element arrangement (H) which is fed by a Hall current (IH) and generates a Hall signal as the sensor signal and comprises a feedback device configured as an amplifying means (RV) which is supplied with the first output signal and controls the Hall current.

**3.** The magnetic field sensor according to claim 1 or 2, **characterized in that** the first output signal corresponds to the actual-value amplitude (AI) of the sensor signal and the feedback device (RV) adjusts the supply device by means of a predetermined set-point amplitude (AS) such that the actual-value amplitude of the sensor signal remains constant.

**4.** The magnetic field sensor according to any one of claims 2 or 3, **characterized in that** the Hall element arrangement detects a rotating magnetic field, and a second output signal (W) of the evaluation device corresponds to the determined angle of rotation.

**5.** The magnetic field sensor according to any one of claims 2 to 4, **characterized in that** the Hall signal of the Hall element arrangement comprises a first measured signal (sin W) and a second measured signal (cos W) which is phase-shifted by 90° with respect to the first measured signal.

**6.** The magnetic field sensor according to any one of claims 1 to 5, **characterized in that** the evaluation device comprises an analog-digital converter (ADC) which digitizes the sensor signal, and a computing means (R ) connected downstream which generates the first and/or the second output signal (AI, W).

**7.** The magnetic field sensor according to any one of claims 1 to 6, **characterized in that** the feedback device comprises a comparator (K) which compares the first output signal (A1) with a reference value (AS), a counter (Z) is connected downstream of the comparator which is supplied the output signal of the comparator, and a digital-analog converter (DAC) is connected downstream of the counter which converts the output signal of the counter into a control signal for the supply device.

**8.** A method for operating a magnetic field sensor, in particular a magnetic field sensor according to any one of claims 1 to 6, in which a supply device supplies a sensor element of the magnetic field sensor, and the sensor element generates a sensor signal which is processed into a first output signal (AI) corresponding to the amplitude of the sensor signal by an evaluation device (ADC, R) and supplied to a feedback device (RV) which, at the output side of the feedback device (RV), controls the supply device such that the first output signal remains constant.

**9.** The method according to claim 8, **characterized in**

**that** the actual-value amplitude (AI) of the sensor signal is derived from the first output signal, and the feedback device (TV) adjusts the supply device by means of a predetermined set-point amplitude (AS) such that the actual-value amplitude of the sensor signal remains constant.

**10.** The method according to claim 8 or 9, **characterized in that** a rotating magnetic field is detected using the sensor element and a second output signal (W) corresponding to the angle of rotation is generated using the evaluation device.

**11.** The method according to any one of claims 8 to 10, **characterized in that** a sensor element configured as a Hall element arrangement is arranged such that the Hall signal comprises a first measured signal (sin W) and a second measured signal (cos W) which is phase-shifted by 90° with respect to the first measured signal.

**12.** The method according to any one of claims 8 to 11, **characterized in that** the evaluation device digitizes the sensor signal using an analog-digital converter (ADC), and a computing means (R) connected downstream of the evaluation device generates the first and/or the second output signal (AI, W).

**13.** The method according to any one of claims 8 to 12, **characterized in that** the first output signal (AI) is compared with a reference value (AS) in a comparator, a counter (Z) connected downstream of the comparator derives a count value from the output signal of the comparator, and a digital-analog converter (DAC) converts the output signal of the counter into a control signal for the supply device.

## Revendications

**1.** Capteur à champ magnétique pourvu d'un ensemble capteur (H) qui est alimenté par un dispositif d'alimentation et qui produit un signal de capteur, d'un dispositif d'évaluation (ADC, R) auquel est acheminé le signal de capteur et qui délivre un premier signal de sortie (AI) correspondant à l'amplitude du signal de capteur, et d'un dispositif de rétrocouplage (RV) auquel est acheminé le premier signal de sortie, **caractérisé en ce que** le dispositif d'alimentation est commandé de telle sorte que le premier signal de sortie reste constant.

**2.** Capteur à champ magnétique selon la revendication 1, **caractérisé en ce que** l'ensemble capteur comporte un ensemble d'éléments de Hall (H) qui est alimenté par un courant de Hall (IH) et qui produit un signal de Hall comme signal de capteur, et présentant un dispositif de rétrocouplage réalisé comme dispositif d'amplification (RV) auquel est acheminé le premier signal de sortie et qui commande le courant de Hall.

**3.** Capteur à champ magnétique selon la revendication 1 ou 2, **caractérisé en ce que** le premier signal de sortie correspond à l'amplitude effective (AI) du signal de capteur et **en ce que** le dispositif de rétrocouplage (RV) règle le dispositif d'alimentation à l'aide d'une amplitutde théorique prédéfinie (AS) de telle façon que l'amplitude effective du signal de capteur reste constante.

**4.** Capteur à champ magnétique selon l'une des revendications 2 ou 3, **caractérisé en ce que** l'ensemble d'éléments de Hall détecte un champ magnétique tournant et **en ce qu'**un deuxième signal de sortie (W) du dispositif d'évaluation correspond à l'angle de rotation déterminé.

**5.** Capteur à champ magnétique selon l'une des revendications 2 à 4, **caractérisé en ce que** le signal de Hall de l'ensemble d'éléments de Hall comporte un premier signal de mesure (sin W) ainsi qu'un deuxième signal de mesure (cos W) qui présente un décalage de phase de 90° par rapport au premier signal de mesure.

**6.** Capteur à champ magnétique selon l'une des revendications 1 à 5, **caractérisé en ce que** le dispositif d'évaluation comporte un convertisseur analogique-numérique (ADC) qui numérise le signal de capteur et un dispositif de calcul (R) placé en aval qui produit le premier et/ou le deuxième signal de sortie (AI, W).

**7.** Capteur à champ magnétique selon l'une des revendications 1 à 6, **caractérisé en ce que** le dispositif de rétrocouplage comporte un comparateur (K) qui compare le premier signal de sortie (AI) à une valeur de référence (AS), **en ce qu'**un compteur (Z) auquel est acheminé le signal de sortie du comparateur, est placé en aval du comparateur, et **en ce qu'**un convertisseur numérique-analogique (DAC) qui convertit le signal de sortie du compteur en un signal de commande pour le dispositif d'alimentation, est placé en aval du compteur.

**8.** Procédé de fonctionnement d'un capteur à champ magnétique, en particulier d'un capteur à champ magnétique selon l'une des revendications 1 à 6, dans lequel un dispositif d'alimentation alimente un élément de capteur du capteur à champ magnétique et l'élément de capteur produit un signal de capteur qui est traité par un dispositif d'évaluation (ADC, R) en un premier signal de sortie (AI) correspondant à l'amplitude du signal de capteur et qui est acheminé à un dispositif de rétrocouplage (RV) qui commande en sortie le dispositif d'alimentation de telle façon que le premier signal de sortie reste constant.

**9.** Procédé selon la revendication 8, **caractérisé en ce que** l'amptitude effective (AI) du signal de capteur est dérivée du premier signal de sortie et le dispositif de rétrocouplage (RV) règle le dispositif d'alimentation à l'aide d'une amplitude théorique prédéfinie (AS) de telle façon que l'amplitude effective du signal de capteur reste constante.

**10.** Procédé selon la revendication 8 ou 9, **caractérisé en ce qu'**un champ magnétique tournant est détecté au moyen de l'élément de capteur et **en ce qu'**un deuxième signal de sortie (W) qui correspond à l'angle de rotation est produit avec le dispositif d'évaluation.

**11.** Procédé selon l'une des revendications 8 à 10, **caractérisé en ce qu'**un élément de capteur réalisé comme ensemble d'éléments de Hall est disposé de telle façon que le signal de Hall comporte un premier signal de mesure (sin W) ainsi qu'un deuxième signal de mesure (cos W) qui présente un décalage de phase de 90° par rapport au premier signal de mesure.

**12.** Procédé selon l'une des revendications 8 à 11, **caractérisé en ce que** le dispositif d'évaluation numérise le signal de capteur au moyen d'un convertisseur analogique-numérique (ADC) et **en ce qu'**un dispositif de calcul (R) placé en aval du dispositif d'évaluation produit le premier et/ou le deuxième signal de sortie (AI, W).

**13.** Procédé selon l'une des revendications 8 à 12, **caractérisé en ce que** le premier signal de sortie (AI) est comparé dans un comparateur à une valeur de référence (AS), **en ce qu'**un compteur (Z) placé en aval du comparateur dérive une valeur de comptage du signal de sortie du comparateur et **en ce qu'**un convertisseur numérique-analogique (DAC) convertit le signal de sortie du compteur en un signal de commande pour le dispositif d'alimentation.

## FIG 1

EP 1 721 183 B1

## FIG 2

AI

AS

K

Z

DAC

U

D

## FIG 3

DA

M

N

S

SE

SE

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0525235 B1
- DE 4431703 A1

- US 5477135 A
- EP 0916074 B1

**In der Beschreibung aufgeführte Nicht-Patentliteratur**

- *IEEE Transactions on Circuits and Systems - II: Analog and Digital Signal Processing,* Juni 2001, vol. 48 (6), 548-561